# EUROPEAN PATENT SPECIFICATION

(11) **EP 0 910 135 B1**
(45) Date of publication and mention of the grant of the patent: **21.05.2003**
(21) Application number: 98402316.8
(22) Date of filing: 18.09.1998
(51) Int. Cl.: H01R 12/22, H05K 7/10, G01R 1/04

(54) **Extended core connector**
Erweiterter Koaxialsteckverbinder
Connecteur coaxial prolongé

(30) Priority: 18.09.1997 US 59237 P
(43) Date of publication of application: 21.04.1999
(73) Proprietor: JOHNSTECH INTERNATIONAL CORPORATION, Minneapolis, Minnesota 55413 (US)
(72) Inventor: Kline, Eric V., Stillwater, Minnesota 55082 (US)
(74) Representative: Derambure, Christian

(56) References cited:
- US-A- 4 707 656
- US-A- 5 069 629
- US-A- 5 506 513

## Description

### BACKGROUND OF THE INVENTION

1. **Field of the Invention** - The present invention relates to an interconnecting device and more specifically, to an Extended Core Connector (ECC) device which is incorporated into a controlled impedance contactor.

2. **Description of the Prior Art** - Devices and methods for effecting electrical interconnection between two conductors are generally known. A specialized area of such interconnection has been recently expanding with the advent of integrated circuit technology. For example, in the manufacturing process for fabricating integrated circuit devices, each integrated circuit must be tested for operativeness. Thus, each lead of an integrated circuit device must be interconnected with a tester apparatus, wherein the tester apparatus may determine the functionality and performance of the corresponding circuit device.

During such testing, an integrated circuit device is typically placed into an interconnect device (such as a test socket). The interconnect device interconnects each lead of the integrated circuit with a corresponding terminal of a printed circuit board. This may be accomplished with a number of contacts within the interconnect device. A tester apparatus is then electrically coupled to the printed circuit board such that the signals provided to each lead of the integrated circuit may be controlled and/or observed by the tester apparatus.

Another specialized area of interconnecting electrical contacts focuses on the interconnection of two printed circuit boards. These interconnections have applications utilizing insertable boards, such as memory cards, or multi-chip boards which are highly miniaturized and integrated.

Several technologies for packaging an integrated circuit chip into a semiconductor package have been developed. These may be generally categorized as pin grid array (PGA) systems and leaded semiconductor devices. The leaded semiconductor devices include plastic leaded chip carriers (PLCC), dual in-line packages (DIP) and Quad Flat Pack (QFP). Each packaging type requires a particular array of leads to be interconnected with a printed circuit board.

A number of methods for connecting integrated circuits, such as PGA devices, with a printed circuit board are known. It is believed that limitations to these systems are the contact length and the usual requirement of mounting the contacts in through-holes located in a printed circuit board. The contact and through-hole mounting limits the mounting speed of the semiconductor device while inducing discontinuities and impedance which cause signal reflections back to the source. Further, the design causes high lead inductance and thus problems with power de-coupling and may result in cross-talk with closely adjacent signal lines.

Johnson recently disclosed in U.S. Patents No. 5,069,629 (issued December 3, 1991) and No. 5,207,584 (issued May 4, 1993) electrical interconnect contact systems which are directed to addressing both mechanical and electrical considerations of such systems.

The disclosures of Johnson are directed to an interconnect device which comprises a generally planar contact which is received within one or more slots of a housing. In one embodiment, each contact is of a generally S-shaped design and supported at two locations (the hook portions of the S) by a rigid first elements and an elastomeric second element. As disclosed, the Johnson electrical interconnect provides a wiping action which enables a good interface to be accomplished between the contact and the lead of the integrated circuit, and between the contact and terminals on a printed circuit board. Further, Johnson discloses an electrical contact that can sustain high operating speeds, and provides a very short path of connection. Such a contact may have low inductance and low resistance, thereby minimizing the impedance of the contact.

An important consideration of interconnect devices is the impedance provided by the corresponding contacts. It is recognized that the interconnect path between, for example, a semiconductor package lead and a terminal on a printed circuit board, should have a relatively high and stable bandwidth across all applicable frequencies. That is, not only should the impedance of the interconnect system be minimized as disclosed in Johnson, but the impedance should also be controlled such that a relatively flat bandpass over all applicable frequencies exists.

To achieve a stable bandpass, it is often important to have a contact which provides impedance matching between a corresponding input of an integrated circuit and the corresponding driver. For example, if a tester is driving an input of an integrated circuit device via an interconnect device, it may be important for the interconnect device to provide an impedance such that the impedance of the driver matches the input impedance of the integrated circuit. Since the input impedance of the integrated circuit is often fixed, the impedance of the interconnect device may be used to correct for any impedance mismatch between the driver and the integrated circuit. Impedance matching may be important to minimize reflections and other noise mechanisms which may reduce the reliability and accuracy of the corresponding system.

Another major problem facing the current state of the art of semiconductor contacting is device operating speed. The wireless market is presently driving Low Noise Amplifier (LA) speeds to ca 5.8 HZ.

The impedance matching/performance problems described in the preceding paragraphs have been addressed in large measure by a contact described in US application serial no. 08/677,605, (see EP-A-0 752 741) entitled "IMPEDANCE CONTROLLED INTERCONNECTION DEVICE", filed July 5, 1996. That invention allows the impedance of each contact in the interconnect system to be controlled to provide a stable bandpass, and the impedance may be programmable to match, or correct for, the input impedance of a corresponding device.

However, the technology described in the 08/677,605 application requires the contact manufacturer or customer to design and fabricate RF routing substrates for each new contact application. In the vast majority of instances, customers do not have the intimate knowledge of the design rules/guidelines required to interface to the contact described in the 08/677,605 application.

### SUMMARY OF THE INVENTION

The present invention is defined in independent claims 1 and 10, preferred realisation in the dependent claims.

The present invention overcomes many of the disadvantages associated with the prior art by providing an improvement to an impedance controlled contactor (such as described in US application 08/677,605) wherein an Extended Core Connector (ECC) is incorporated within the impedance controlled contactor. The introduction of an ECC within the impedance controlled contactor offers several advantages, including: 1) a 50 ohm signal path is provided from the signal source (tester) all the way to the distal aspect of the S-contact with a minimum of transitions, and 2) no routing substrate is required. That is, the impedance controlled contactor can be mounted on a conventional load board (DUT board, BID, etc.) without compromise of RF fidelity.

The ECC is that portion of the coaxial connector, consisting of the dielectric and center (signal) conductor, which, in the present invention, is extended beyond its native ground reference (i.e. connector body) by the length required to span the distance between the connector (RFin) and an S-contact of the impedance controlled contactor described in US application 08/677,605. The metal housing of the impedance controlled contactor described in US application 08/677,605 has a corresponding channel which accommodates the ECC's path from said termination to said termination; thus, the impedance controlled contactor's housing provides the ground reference for the ECC.

In an alternative embodiment, an additional outer metal jacket is placed around the perimeter of the ECC described above, in order to provide an integral ground reference for the ECC, independent of the contactor housing. This allows the housing of the contactor to be constructed of a nonconductive material, such as TORLON. In this metal core connector (MCC) embodiment, a center signal conductor is surrounded by a dielectric material, with the dielectric material, in turn, surrounded by a metal jacket having excellent RF conducting characteristics (such as copper). Just as in the ECC embodiment, the MCC spans the distance between, and electrically connects, the contacts with a signal source, thus creating a signal path of a pre-determined impedance (e.g., 50 ohms).

### BRIEF DESCRIPTION OF THE DRAWINGS

Other objects of the present invention and many of the attendant advantages of the present invention will be readily appreciated as the same becomes better understood by reference to the following detailed description when considered in connection with the accompanying drawings, in which like reference numerals designate like parts throughout the figures thereof and wherein:
**Figure 1** illustrates an exploded view of the contactor housing and the extended core connector (ECC) device;
**Figure 2** is a view of an extended core connector from a lengthwise perspective;
**Figure 3** is a lengthwise cross-sectional view of the interaction between an elastomeric S-contact and the extended core connector (ECC);
**Figure 4** is a lengthwise cross-sectional view of the interaction between an elastomeric S-contact and the extended core connector (ECC), further showing a co-axial connector positioned at the end of the ECC;
**Figure 5** illustrates a lengthwise view of an extended core connector (ECC) with a first embodiment of a co-axial connector positioned at an end of the ECC;
**Figure 6** illustrates a widthwise cross-sectional view of the extended core connector;
**Figure 7** illustrates a lengthwise view of an extended core connector (ECC) with a second embodiment of a co-axial connector positioned at an end of the ECC;
**Figure 8** illustrates a cross sectional view of an entire contactor assembly with two extended core connectors installed;
**Figure 9** illustrates a top cross sectional view of the interaction between the extended core connector (ECC) and a set of elastomeric S-contacts in a first configuration; and
**Figure 10** illustrates a top cross sectional view of the interaction between the extended core connector (ECC) and a set of elastomeric S-contacts in a second configuration.

### DETAILED DESCRIPTION OF THE INVENTION

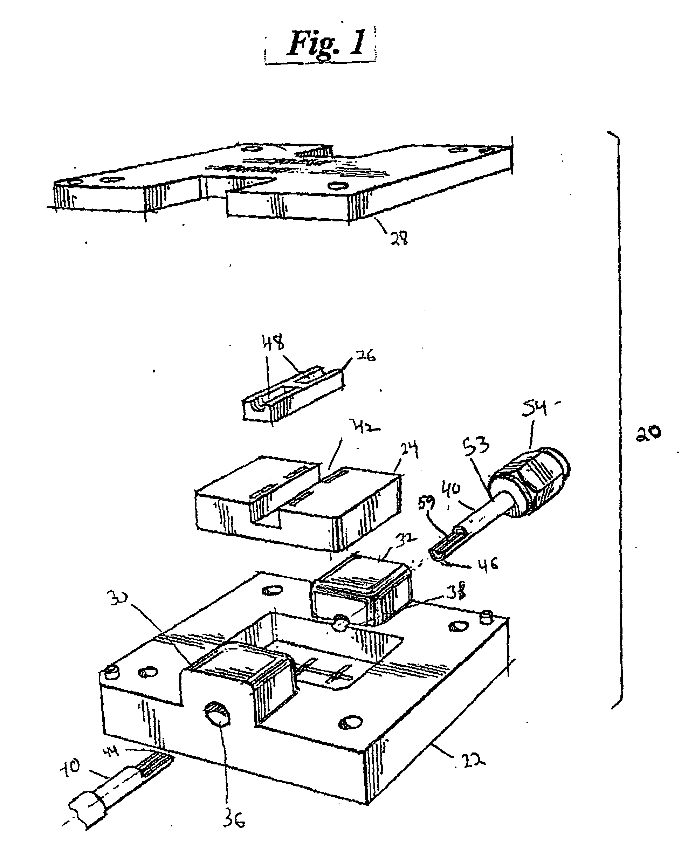

**Figure 1** illustrates an exploded view of a contactor housing 20 with an extended core connector (ECC) device 40 incorporated therein. In this illustrative embodiment, the housing shown is derived from a controlled impedance contactor system of JohnsTech International Corporation, the assignee herein. The contactor housing includes a contactor base plate 22, a contact positioning plate 24 positioned within the center area of the contactor base plate 22, a ECC center plate 26, positioned within the center area of the contact positioning plate 24, and a contactor top plate 28 positioned over the contactor base plate 22, the contact positioning plate 24, and the ECC center plate 26. In a preferred embodiment, the contactor housing provides the ground reference for the ECC 40.

The present invention provides important advantages over the prior art. In a preferred embodiment, a 50 ohm co-axial signal path is now provided from a signal source such as a tester (not shown) all the way to the S-contacts on the interior of the contactor assembly with a minimum of transitions. Also, no RF routing substrate is required. That is, a controlled impedance contactor with the present invention incorporated therein can be mounted on a conventional load board (DUT board, BID, etc.) without compromise of RF fidelity.

The contactor base plate 22 has two protruding blocks 30 and 32 positioned at opposing sides of the base plate 22. Holes 36 and 38 extend through the protruding blocks 30 and 32, respectively, such that an extended core connector (ECC) 40 may be passed through the hole 36 and 38. When deployed, the ECC 40 will rest within the channel area of the contact positioning plate 24, such that the proximal ends of the ECC 44 and 46 will rest in the one of cavities 48 formed in the ECC center plate 26. A coaxial connector 54 can be found at the distal end 53 of the extended core connector 40.

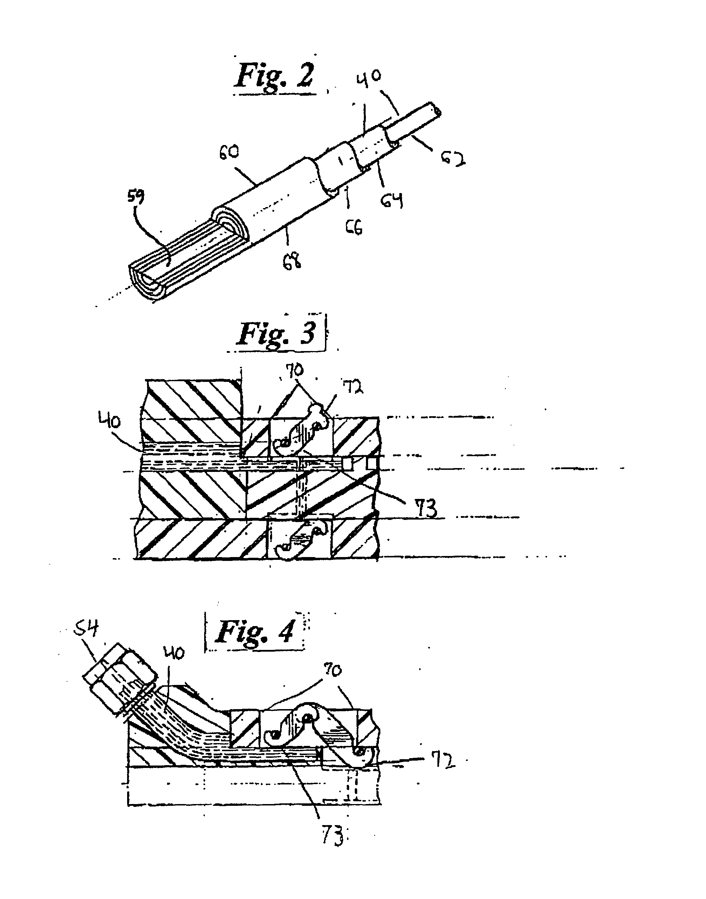

**Figure 2** is a view of an extended core connector 40 in perspective showing a flat 59 which is engaged by a contact 72, as best seen in Figure 3. The extended core connector is that portion of a co-axial connector 60, consisting of a center (signal) conductor 62, and a surrounding dielectric layer 64. In the present invention, the ECC 40 is extended beyond its native ground reference (the connector body) by the length required to span the distance between a co-axial connector (Fig. 1, element 54) located at an outer edge of the contactor body (RFin) and an S-contact located at the interior of the contactor aseembly. The metal housing of the contactor assembly 22, 24, 26 and 28 has a corresponding channel (as shown in Fig. 1) which accommodates the ECC's 40 path from termination to termination. Thus, in a preferred embodiment, the contactor housing 22, 24, 26 and 28 provides the ground reference for the ECC 40. The figures show "notched out" area defining flat 59.

In an alternative embodiment, a metal jacket layer 66 (such as copper) is added around the dielectric layer 66 in order to provide an integral ground reference for the ECC 40. This new structure is generally known as an Metal core Connector (MCC). The MCC is specifically designed to be employed in contactors where the housing body is manufactured from materials (such as TORLON) which are not capable of providing a ground reference for the ECC.

**Figure 3 and 4** illustrate a lengthwise cross-sectional view of the interaction between an elastomeric S-contact 72 and the extended core connector (ECC) 40. In the interior of the contact assembly, an area 70 of the extended core connector 40 is "notched out" (i.e., cut through the dielectric layer 64), such that an S-contact can directly reach the signal conductor portion 62 of the ECC 40, at a contact site 73. Figure 4 further illustrates a co-axial connector 54 located at the distal end of the ECC 40.

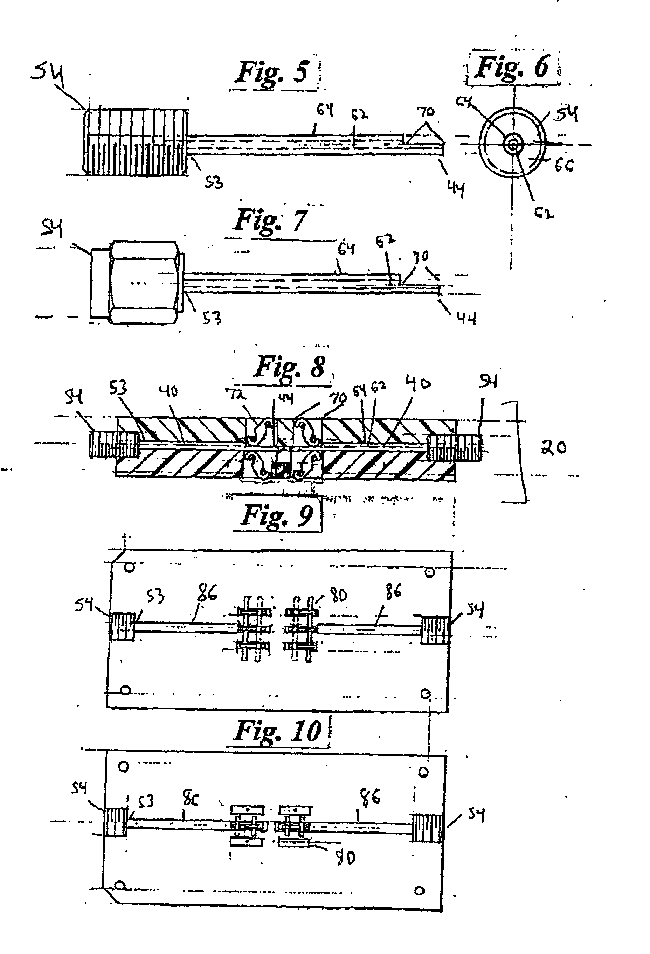

**Figures 5 and 7** illustrate a lengthwise view of an extended core connector (ECC) 40 showing two differing embodiments of a co-axial connector 54 positioned at the distal end 53 of the ECC 40. A cutaway area 70 is shown at the proximal end 44 of the ECC, wherein an area of the extended core connector 70 is "notched out" (i.e., cut through the dielectric layer 64) such that an S-contact can electrically contact the signal conductor portion 62 of the ECC 40. The figures show "notched out" area defining flat 59.

**Figure 6** illustrates a widthwise cross-sectional view of a co-axial connector 54. The outer perimeter of the co-axial connector is shown at 54. A metal ground layer 66 is next located within the perimeter defined by the co-axial connector 54. The dielectric layer 64 is located within the perimeter defined by the metal ground layer 66. The signal conductor layer 62 is located within the perimeter defined by the dielectric layer 64. The signal layer 62, taken together with the dielectric layer 64, form the extended core connector (ECC) 40.

**Figure 8** illustrates a cross sectional view of an entire contactor assembly 20 with two extended core connectors 40 installed on opposing sides of the contactor assembly 20. A co-axial connector is attached at the distal end 53 of each of the ECCs 40. A portion of the ECC 40 is "notched out" 70 (the dielectric layer 64 is cut away so that the signal layer 62 is exposed) at the proximal end of the ECC 40, such that an S-contact 72 may come into electrical contact with the signaI layer 62.

**Figures 9 and 10** illustrate a top cross sectional view of two alternative embodiments showing the interaction between channels formed 86 within the contactor housing for holding the ECC 40, and a set of pockets 80 formed within the contactor housing for holding elastomeric S-contact structures 72. Two channels 84 extend from co-axial connectors 54 located at opposite sides of the contactor assembly, to one or more S-contact pockets 80 located within the interior of the contact assembly.

Having thus described the preferred embodiments of the present invention, those of skill in the art will readily appreciate that the teachings found herein may be applied to yet other embodiments within the scope of the claims hereto attached.

## Claims

1. An interconnecting device for improving the adaptibility and performance of a high frequency, controlled impedance semiconductor socket/contactor, comprising :
- a housing (22, 24, 26, 28) having a plurality of contacts (72) for interconnecting leads of two cricuit devices, **characterised in that** it comprises at least one channel (36, 38) allowing at least one of said plurality of contacts to contact a signal source;
and an extended core connector (40) containing said signal source, placed within said channel , so that one end of said extended core connector (40) is allowed to contact at least one of said plurality of contacts,
and **in that**, said housing providing a ground reference, the extended core connector (40) has a center signal conductor (62) surrounded by a layer (64) of dielectric material, the layer of dielectric material covering almost all the surface of the center signal conductor, and **in that** said extended core connector (40) spans the distance between, and electrically connects, said at least one of said plurality of contacts with said signal source, thus creating a signal path of a predetermined impedance, said extended core connector (40) being notched out (74) to make said center signal conductor (62) engageable by said at least one of said plurality of contacts, said dielectric material preventing said center signal conductor from contacting said housing.

2. A device in accordance with claim 1, wherein said housing is made of a material having excellent RF conducting characteristics, such that said housing provides a ground reference for said extended core connector (40).

3. A device in accordance with claim 2, wherein said material is a metal.

4. A device in accordance with claim 3, wherein said material is aluminum.

5. A device in accordance with claim 1, wherein the entirety of said signal path is maintained at approximately 50 ohms with a minimum of impedance transitions.

6. A device in accordance with claim 1, wherein said apparatus requires no RF routing on a substrate.

7. A device in accordance with claim 1, wherein said signal source is a tester apparatus.

8. A device in accordance with claim 1, wherein said extended core connector (40) maintains a continuous 50 ohm coaxial mode of EM signal propagation from the signal source to said at least one of said plurality of contacts.

9. A device in accordance with Claim 1 wherein said extended core connector (40) has a first end engageable by a plurality of contacts and a second end connectable to said signal source, said first end of said extended core connector defining a flat (50), engageable by said a plurality of contacts, to accomplish electrical interface connection between said plurality of contacts and said extended core connector.

10. An interconnecting device for improving the adaptibility and performance of a high frequency, controlled impedance semiconductor socket/contactor, comprising :
- a housing (22, 24, 26, 28) having a plurality of contacts (72) for interconnecting leads of two circuit devices, **characterised in that** it comprises, with at least one channel (36,38) allowing at least one of said plurality of contacts to contact a signal source;
and a metal core connector (40) containing said signal source, placed within said channel , so that one end of said metal core connector (40) is allowed to contact at least one of said plurality of contacts,
and **in that**, the metal core connector (40) has a center signal conductor (62) surrounded by a layer (64) of dielectric material, the layer of dielectric material covering almost all the surface of the center signal conductor, with said dielectric material (64), in turn surrounded by a metal jacket (66), and **in that** said metal core connector (40) spans the distance between, and electrically connects, said at least one of said plurality of contacts with said signal source, thus creating a signal path of a predetermined impedance, said metal core connector (40) being notched out (59) to make said center signal conductor (62) engageable by said at least one of said plurality of contacts, said metal jacket (66) acting as a ground reference and said dielectric material preventing said center signal conductor from contacting said metal jacket.

11. A device in accordance with claim 10, wherein said metal jacket (66) is made of a metal having excellent RF conducting characteristics, such that said metal jacket provides a ground reference for said metal core connector (40).

12. A device in accordance with claim 11, wherein said material is copper.

13. A device in accordance with claim 10, wherein the entirety of said signal path is maintained at approximately 50 ohms with a minimum of impedance transitions.

14. A device in accordance with claim 10, wherein said apparatus requires no routing substrate.

15. A device in accordance with claim 10, wherein said signal source is a tester apparatus.

16. A device in accordance with claim 10, wherein a co-axial connector interfaces said signal source with said metal core connector (40).

## Patentansprüche

1. Zwischenverbindungsvorrichtung zur Verbesserung der Anpassungsfähigkeit und der Leistung einer Hochfrequenz-Buchse / eines Hochfrequenz-Anschlusses mit kontrollierter Impedanz, umfassend:
- ein Gehäuse (22, 24, 26, 28) mit einer Vielzahl von Kontakten (72) für Zwischenverbindungselemente von zwei Schaltkreisvorrichtungen, **dadurch gekennzeichnet, dass** es wenigstens einen wenigstens einem aus der Vielzahl von Kontakten das Kontaktieren einer Signalquelle erlaubenden Kanal (36, 38) umfasst;
- und einen erweiterten Kern-Anschluss (40) mit besagter, in den besagten Kanal platzierten Signalquelle, so dass ein Ende des besagten erweiterten Kern-Anschlusses (40) wenigstens einen aus der Vielzahl von Kontakten kontaktieren kann,
und darin, dass in besagtem, eine Grundreferenz lieferndem Gehäuse der erweiterte Kern-Anschluss (40) einen zentralen, von einer Schicht (64) dielektrischen Materials überlagerten Signalleiter (62) hat, wobei die Schicht dielektrischen Materials fast die gesamte Fläche des zentralen Signalleiters abdeckt, und darin, dass die besagten erweiterten Kern-Anschlüsse die Entfernung zwischen besagtem wenigstens einem aus besagter Vielzahl von Kontakten mit besagter Signalquelle überbrückt und elektrisch verbindet, wodurch ein Signalpfad einer vorbestimmten Impedanz geschaffen wird, wobei besagte erweiterter Kern-Anschlüsse (40) eingekerbt (74) sind, um den besagten zentralen Signalleiter (62) durch besagten wenigstens einen aus einer Vielzahl von Kontakten eingreifbar zu machen, wobei das besagte dielektrische Material den besagten zentralen Signalleiter am Kontaktieren des besagten Gehäuses hindert.

2. Vorrichtung gemäß Anspruch 1, in der das besagte Gehäuse aus einem Material mit ausgezeichneten leitenden Merkmalen für Funkfrequenzen ist, so dass das besagte Gehäuse eine Grundreferenz für den besagten erweiterten Kern-Anschluss (40) liefert.

3. Vorrichtung gemäß Anspruch 2, in der das besagte Material ein Metall ist.

4. Vorrichtung gemäß Anspruch 3, in der das besagte Material Aluminium ist.

5. Vorrichtung gemäß Anspruch 1, in der der gesamte Signalpfad bei ungefähr 50 Ohm bei einem minimalen Impedanzübergang gehalten wird.

6. Vorrichtung gemäß Anspruch 1, in der das besagte Gerät keinen Funkfrequenz-Leitweg auf einem Substrat erfordert.

7. Vorrichtung gemäß Anspruch 1, in der die besagte Signalquelle ein Testgerät ist.

8. Vorrichtung gemäß Anspruch 1, in der der besagte erweiterte Kern-Anschluss (40) einen kontinuierlichen axialen Modus von 50 Ohm einer elektromagnetischen Signalweiterleitung einer Signalquelle an wenigstens einen aus der besagten Vielzahl von Kontakten aufrecht erhält.

9. Vorrichtung gemäß Anspruch 1, in der der besagte erweiterte Kern-Anschluss (40) ein erstes, durch eine Vielzahl von Kontakten eingreifbares Ende und ein zweites, an die besagte Signalquelle anschließbares Ende hat, wobei das besagte erste Ende des besagten erweiterteren Kern-Anschlusses (40) ein durch die besagte Vielzahl von Kontakten eingreifbares flaches Element hat, um zwischen der besagten Vielzahl von Kontakten und dem besagten erweiterten Kem-Anschluss eine elektrische Schnittstellenverbindung herzustellen.

10. Zwischenverbindungsvorrichtung zur Verbesserung der Anpassungsfähigkeit und der Leistung einer Hochfrequenz-Buchse / eines Hochfrequenz-Anschlusses mit kontrollierter Impedanz, umfassend:
- ein Gehäuse (22, 24, 26, 28) mit einer Vielzahl von Kontakten (72) für Zwischenverbindungselemente von zwei Schaltkreisvorrichtungen, **dadurch gekennzeichnet, dass** es wenigstens einen wenigstens einem aus der Vielzahl von Kontakten das Kontaktieren einer Signalquelle erlaubenden Kanal (36, 38) umfasst;
- und einen metallischen Kern-Anschluss (40) mit besagter, in den besagten Kanal platzierten Signalquelle, so dass ein Ende des besagten erweiterten Kern-Anschlusses (40) wenigstens einen aus der Vielzahl von Kontakten kontaktieren kann,
und darin, dass der metallische Kem-Anschluss (40) einen von einer Schicht (64) dielektrischen Materials zentralen Signalleiter (62) hat, wobei die Schicht dielektrischen Materials fast die gesamte Fläche des zentralen Signalleiters abdeckt, wobei das besagte dielektrische Material (64) seinerseits durch eine Metallummantelung (66) umgeben ist, und darin, dass der besagte metallische Kern-Anschluss (40) die Entfernung zwischen dem besagten wenigstens einem von einer Vielzahl von Kontakten und der besagten Signalquelle überbrückt und elektrisch verbindet, wodurch ein Signalpfad einer vorbestimmten Impedanz geschaffen wird, wobei der besagte metallische Kem-Anschluss (40) eingekerbt (59) ist; um den besagten wenigstens einen von der besagten Vielzahl von Kontakten eingreifbar zu machen, wobei die besagte Metallummantelung (66) als eine Grundreferenz fungiert und das besagte dielektrische Material den besagten zentralen Signalleiter am Kontaktieren der besagten Metallummantelung hindert.

11. Vorrichtung gemäß Anspruch 10, in der die besagte Metallummantelung (66) aus einem Metall mit ausgezeichneten leitenden Merkmalen für Funkfrequenzen hergestellt ist, so dass die besagte Metallummantelung eine Grundreferenz für den besagten metallischen Kern-Anschluss (40) liefert.

12. Vorrichtung gemäß Anspruch 11, in der das besagte Material Kupfer ist.

13. Vorrichtung gemäß Anspruch 10, in der der gesamte besagte Signalpfad bei ungefähr 50 Ohm mit einem minimalen Impedanzübergang gehalten wird.

14. Vorrichtung gemäß Anspruch 10, in der das besagte Gerät kein Leitweg-Substrat benötigt.

15. Vorrichtung gemäß Anspruch 10, in der die besagte Signalquelle ein Testgerät ist.

16. Vorrichtung gemäß Anspruch 10, in der ein koaxialer Anschluss eine Schnittstelle mit der besagten Signalquelle mit dem besagten metallischen Kern-Anschluss (40) bildet.

## Revendications

1. Dispositif d'interconnexion pour améliorer l'adaptabilité et les performances d'un contacteur/socle à semiconducteur à impédance commandée, à haute fréquence, comprenant :
- un boîtier (22, 24, 26, 28) ayant une pluralité de contacts (72) pour interconnecter des conducteurs de deux composants, **caractérisé en ce qu'**il comprend au moins un canal (36, 38) permettant au moins à un de ladite pluralité de contacts d'entrer en contact avec une source de signal ;
et un connecteur à âme étendue (40) contenant ladite source de signal, placé dans ledit canal, de sorte qu'une extrémité dudit connecteur à âme étendue (40) peut entrer en contact avec au moins un de ladite pluralité de contacts,
et **en ce que**, ledit boîtier fournit une référence à la masse, le connecteur à âme étendue (40) a un conducteur de signal central (62) entouré d'une couche (64) de corps diélectrique, la couche de corps diélectrique recouvre presque toute la surface du conducteur de signal central, et **en ce que** ledit connecteur à âme étendue (40) relie, et raccorde électriquement, ledit au moins un de ladite pluralité de contacts et ladite source de signal, créant de ce fait un trajet de signal d'une impédance prédéterminée, ledit connecteur à âme étendue (40) étant échancré (72) pour permettre l'engagement dudit conducteur de signal central (62) avec ledit au moins un de ladite pluralité de contacts, ledit corps diélectrique empêchant ledit conducteur de signal central d'entrer en contact avec ledit boîtier.

2. Dispositif selon la revendication 1, dans lequel ledit boîtier est constitué d'une matière ayant des caractéristiques de conduction de fréquences radio excellentes, de sorte que ledit boîtier fournit une référence à la masse pour ledit connecteur à âme étendue (40).

3. Dispositif selon la revendication 2, dans lequel ladite matière est un métal.

4. Dispositif selon la revendication 3, dans lequel ladite matière est de l'aluminium.

5. Dispositif selon la revendication 1, dans lequel la totalité dudit trajet de signal est maintenue à approximativement 50 ohms avec un minimum de transitions d'impédance.

6. Dispositif selon la revendication 1, dans lequel ledit appareil n'exige pas d'acheminement de fréquences radio sur un substrat.

7. Dispositif selon la revendication 1, dans lequel ladite source de signal est un appareil de contrôle.

8. Dispositif selon la revendication 1, dans lequel ledit connecteur à âme étendue (40) maintient un mode de propagation de signal EM coaxial de 50 ohms en continu de la source de signal audit au moins un de ladite pluralité de contacts.

9. Dispositif selon la revendication 1, dans lequel ledit connecteur à âme étendue (40) a une première extrémité pouvant s'engager avec une pluralité de contacts et une seconde extrémité pouvant être connectée à ladite source de signal, ladite première extrémité dudit connecteur à âme étendue (40) définissant un méplat pouvant s'engager dans ladite pluralité de contacts pour réaliser une connexion d'interface électrique entre ladite pluralité de contacts et ledit connecteur à âme étendue (40).

10. Dispositif d'interconnexion pour améliorer l'adaptabilité et les performances d'un contacteur/socle à semiconducteur à impédance commandée, à haute fréquence, comprenant :
- un boîtier (22, 24, 26, 28) ayant une pluralité de contacts (72) pour interconnecter des conducteurs de deux composants, **caractérisé en ce qu'**il comprend au moins un canal (36, 38) permettant au moins à un de ladite pluralité de contacts d'entrer en contact avec une source de signal ;
et un connecteur à âme métallique (40) contenant ladite source de signal, placé dans ledit canal, de sorte qu'une extrémité dudit connecteur à âme métallique (40) peut entrer en contact avec au moins un de ladite pluralité de contacts,
et **en ce que**, le connecteur à âme métallique (40) a un conducteur de signal central (62) entouré d'une couche (64) de corps diélectrique, la couche de corps diélectrique recouvre presque toute la surface du conducteur de signal central, ledit corps diélectrique (65) étant entouré à son tour par une enveloppe métallique (66), et **en ce que** ledit connecteur à âme métallique (40) relie, et raccorde électriquement, ledit au moins un de ladite pluralité de contacts et ladite source de signal, créant de ce fait un trajet de signal d'une impédance prédéterminée, ledit connecteur à âme métallique (40) étant échancré (59) pour permettre l'engagement dudit conducteur de signal central (62) avec ledit au moins un de ladite pluralité de contacts, ladite enveloppe métallique (66) agissant comme référence à la masse et ledit corps diélectrique empêchant ledit conducteur de signal central d'entrer en contact avec ladite enveloppe métallique.

11. Dispositif selon la revendication 10, dans lequel ladite enveloppe métallique (66) est constituée d'un métal ayant des caractéristiques de conduction de fréquences radio excellentes, de sorte que ladite enveloppe métallique fournit une référence à la masse pour ledit connecteur à âme métallique (40).

12. Dispositif selon la revendication 11, dans lequel ladite matière est du cuivre.

13. Dispositif selon la revendication 10, dans lequel la totalité dudit trajet de signal est maintenue à approximativement 50 ohms avec un minimum de transitions d'impédance.

14. Dispositif selon la revendication 10, dans lequel ledit appareil n'exige pas de substrat d'acheminement.

15. Dispositif selon la revendication 10, dans lequel ladite source de signal est un appareil de contrôle.

16. Dispositif selon la revendication 10, dans lequel un connecteur coaxial sert d'interface à ladite source de signal avec ledit connecteur à âme métallique (40).
